# EUROPEAN PATENT APPLICATION

(11) **EP 2 568 556 A2**
(43) Date of publication of application: **13.03.2013**
(21) Application number: 12169498.8
(22) Date of filing: 25.05.2012
(51) Int. Cl.: H02G 15/013, H02G 15/04

(54) **Connector-connecting terminal treatment structure for shielded wires and method of producing connector-connecting terminal treatment structure for shielded wires**

(30) Priority: 07.09.2011 JP 2011194891
(71) Applicant: Sumitomo Wiring Systems, Ltd., Yokkaichi-city, Mie 510-8503 (JP)
(72) Inventor: Kawakita, Hiromichi, Yokkaichi-City, Mie 510-8503 (JP); Ito, Takeharu, Yokkaichi-city, Mie 510-8503 (JP); Fukuda, Takao, Yokkaichi-city, Mie 510-8503 (JP)
(74) Representative: Chettle, Adrian John

(57) **Abstract**

A plurality of shielded wires 20 are waterproofed by applying a sealing paste 32 to the boundary between exposed wire strands 24 and a wire cover 28. The sealing paste is tightly covered by a sheet-like cover 40 through which the paste does not penetrate.

## Description

### FIELD OF THE INVENTION

The present invention relates to a connector-connecting terminal treatment technology for shielded wires.

### BACKGROUND OF THE INVENTION

Related Art 1 discloses a technology that provides a waterproof function at a wire core exposed portion in which a wire core of a shielded wire is exposed. In shielding structure of the shielded wire in Related Art 1, the wire core exposed portion is covered by a paste sealing material that is configured with a conductive self-fusion adhesive material, such as butyl rubber and the like. The surface of the sealing material is wrapped by a sheet or tape outer cover.

### RELATED ART

### Patent Literature

Related Art 1: Japanese Patent Laid-open Publication No. 2007-109684

### SUMMARY OF THE INVENTION

### Problems to Be Solved by the Invention

In Related Art 1, however, the outer cover wraps around only the surface of the sealing material. Accordingly, there is a case where the sealing material leaks or migrates to the lateral sides of the outer cover when the sealing material is pressured so as to be more tightly attached to the wire core exposed portion. In addition, there is a demand for a waterproof function that can be imparted to a plurality of shielded wires as a whole. In such a case, gaps are formed among the wire core exposed portions and among sheaths of the plurality of shielded wires. Leaking of the sealing material thus becomes more likely. When the sealing material leaks to the lateral sides of the outer cover, the amount of the sealing material to be kept at the portion intended to be waterproofed is reduced, which may adversely affect a waterproof capability.

Thus, an object of the present invention is to integrally treat a plurality of shielded wires while securing the waterproof capability by keeping a waterproof agent at a portion to be waterproofed.

### Means for Solving the Problems

A first aspect of the present invention is a connector-connecting terminal treatment structure for shielded wires, a terminal portion of which is connected to a connector, including: a plurality of shielded wires arranged in parallel to one another; a first water stopper configured with a paste waterproof agent; and a second water stopper having a sheet shape through which the paste waterproof agent does not penetrate. The plurality of shielded wires each is configured with a strand and a ground wiring covered with a sheath and having an exposed strand portion in which the strand is exposed at a terminal portion and a covered portion in which the strand and the ground wiring are covered with the sheath. The first water stopper integrally covers a boundary portion between the exposed strand portions and the covered portions of the plurality of shielded wires. The second water stopper covers an outer periphery of the first water stopper as well as tightly attaching to an outer periphery of the covered portions and the exposed strand portions on both the lateral sides of the first water stopper in an extending direction of the plurality of shielded wires.

A second aspect of the present invention is the connector-connecting terminal treatment structure for shielded wires according to the first aspect, in which the first water stopper also exists among the strands and among the sheaths at the boundary portion between the exposed strand portions and the covered portions.

A third aspect of the present invention is the connector-connecting terminal treatment structure for shielded wires according to one of the first and second aspects, in which the second water stopper is configured with a closed-cell foam resin sheet.

A fourth aspect of the present invention is the connector-connecting terminal treatment structure for shielded wires according to one of the first to third aspects, further including a fastener winding around an outer periphery of the second water stopper on at least one lateral side of the first water stopper in the extending direction of the shielded wires.

A fifth aspect of the present invention is the connector-connecting terminal treatment structure for shielded wires according to one of the first to fourth aspects, in which the first water stopper covers end portions of the ground wirings exposed from the sheaths of the covered portions.

A sixth aspect of the present invention is a method of producing a connector-connecting terminal treatment structure for shielded wires that performs a terminal treatment on a plurality of shielded wires, each of the plurality of shielded wires being configured with a strand and a ground wiring covered with a sheath and having an exposed strand portion in which the strand is exposed at a terminal portion and a covered portion in which the strand and the ground wiring are covered with the sheath, the method comprising: (a) arranging the plurality of shielded wires to be in parallel to one another; (b) integrally covering a boundary portion between the exposed strand portions and the covered portions of the plurality of shielded wires with a paste waterproof agent; and (c) wrapping a waterproof sheet, through which the paste waterproof agent does not penetrate, around the plurality of shielded wires so as to cover the paste waterproof agent covering the boundary portion between the exposed strand portions and the covered portions as well as to tightly attach to the outer periphery of the exposed strand portions and the covered portions on both the lateral sides of a portion covered with the paste waterproof agent in the extending direction of the shielded wires.

A seventh aspect of the present invention is the method of producing the connector-connecting terminal treatment structure for shielded wires according to the fifth aspect, further including (d) winding a tape around the outer periphery of the waterproof sheet on at least one lateral side of the portion covered with the paste waterproof agent in the extending direction of the shielded wires.

A eighth aspect of the present invention is the method of producing the connector-connecting terminal treatment structure for shielded wires according to one of the sixth and seventh aspects in which, in (b), an area including end portions of the ground wirings exposed from the sheaths of the covered portions is covered with the paste waterproof agent.

### Effect of the Invention

According to the connector-connecting terminal treatment structure for shielded wires of the first aspect, the first water stopper is configured with the paste waterproof agent that integrally covers the boundary portion between the exposed strand portions and the covered portions. Accordingly, the paste waterproof agent stays, without flowing away, at the portion to be waterproofed. Thereby, it is possible to secure a waterproof capability. In addition, the second water stopper having a sheet shape, through which the paste waterproof agent does not penetrate, covers the outer periphery of the first water stopper and tightly attaches to the outer periphery of the exposed strand portions and the covered portions on both the lateral sides of the first stopper in the extending direction of the shielded wires. Accordingly, the paste waterproof agent before curing is prevented from leaking out from the second water stopper. Thereby, it is possible to integrally treat the plurality of shielded wires while securing the waterproof capability by keeping the waterproof agent at the portion to be waterproofed.

According to the connector-connecting terminal treatment structure for shielded wires of the second aspect, the first water stopper also exists among the strands and among the sheaths at the boundary portion between the exposed strand portions and the covered portions. Accordingly, it is possible to obtain a high waterproof capability.

According to the connector-connecting terminal treatment structure for shielded wires of the third aspect, the second water stopper is configured with a closed-cell foam resin sheet and is thus soft and elastically deformable with ease. Accordingly, the second water stopper tightly attaches to the outer periphery of the shielded wires without forming any gap, thereby more securely preventing the paste waterproof agent from leaking. Thus, it is possible to increase the waterproof capability.

According to the connector-connecting terminal treatment structure for shielded wires of the fourth aspect, the fastener winds around the outer periphery of the second water stopper on the lateral side of the first water stopper in the extending direction of the shielded wires. Accordingly, the second water stopper is more strongly pressed against the outer periphery of the exposed strand portions and the covered portions. Thereby, it is possible to prevent the paste waterproof agent before curing of the first water stopper from straying away in the extending direction of the shielded wires as well as to securely keep the paste waterproof agent before curing at the boundary portion between the exposed strand portions and the covered portions. Thus, it is possible to improve the waterproof capability at the boundary portion between the exposed strand portions and the covered portions.

According to the connector-connecting terminal treatment structure for shielded wires of the fifth aspect, the first water stopper covers the end portions of the drain wires exposed from the sheaths of the covered portions. Accordingly, the water can be securely stopped from penetrating to the drain wires as well.

According to a method of producing a connector-connecting terminal treatment structure for shielded wires of the sixth aspect, the boundary portion between the exposed strand portions and the covered portions in the plurality of shielded wires is integrally covered by the paste waterproof agent. Accordingly, the paste waterproof agent stays, without flowing away, at the portion to be waterproofed, thereby making it possible to secure the waterproof capability. In addition, the waterproof sheet, through which the paste waterproof agent does not penetrate, wraps around the plurality of shielded wires so as to cover the paste waterproof agent covering the boundary portion between the strand covered portions and the covered portions as well as to tightly attach to the outer periphery of the exposed strand portions and the covered portions on both the lateral sides of the portion covered by the paste waterproof agent in the extending direction of the shielded wires. Accordingly, the paste waterproof agent before curing is prevented from leaking out from the waterproof sheet. In addition, it is possible to integrally treat the plurality of shielded wires while securing the waterproof capability by keeping the waterproof agent at the portion to be waterproofed.

According to the method of producing the connector-connecting terminal treatment structure for shielded wires of the seventh aspect, the tape is wound around the outer periphery of the waterproof sheet on the lateral side of the paste waterproof agent in the extending direction of the shielded wires. Accordingly, the waterproof sheet is more strongly pressed against the outer periphery of the exposed strand portions and the covered portions. Thereby, it is possible to securely keep the paste waterproof agent at the boundary portion between the exposed strand portions and the covered portions as well as to improve the waterproof capability.

According to the method of producing the connector-connecting terminal treatment structure for shielded wires of the eighth aspect, the area including the end portions of the drain wires exposed from the sheaths of the covered portions is covered with the paste waterproof agent. Accordingly, the water can be securely stopped from penetrating to the drain wires as well.

### BRIEF DESCRIPTION OF THE DRAWINGS

[Fig. 1] A perspective view of a shielded wire.
[Fig. 2] A diagram showing an applied example of a connector-connecting terminal treatment structure for shielded wires.
[Fig. 3] A diagram showing a plurality of shielded wires arranged in a row.
[Fig. 4] A diagram showing a work to apply a paste waterproof agent.
[Fig. 5] A diagram showing a work to wrap a waterproof sheet.
[Fig. 6] A diagram showing the connector-connecting terminal treatment structure for shielded wires.
[Fig. 7] A cross-sectional view taken along the line VII-VII in Fig. 6.
[Fig. 8] A cross-sectional view taken along the line VIII-VIII in Fig. 6.
[Fig. 9] A cross-sectional view taken along the line IX-IX in Fig. 6.

### MODE FOR CARRYING OUT THE INVENTION

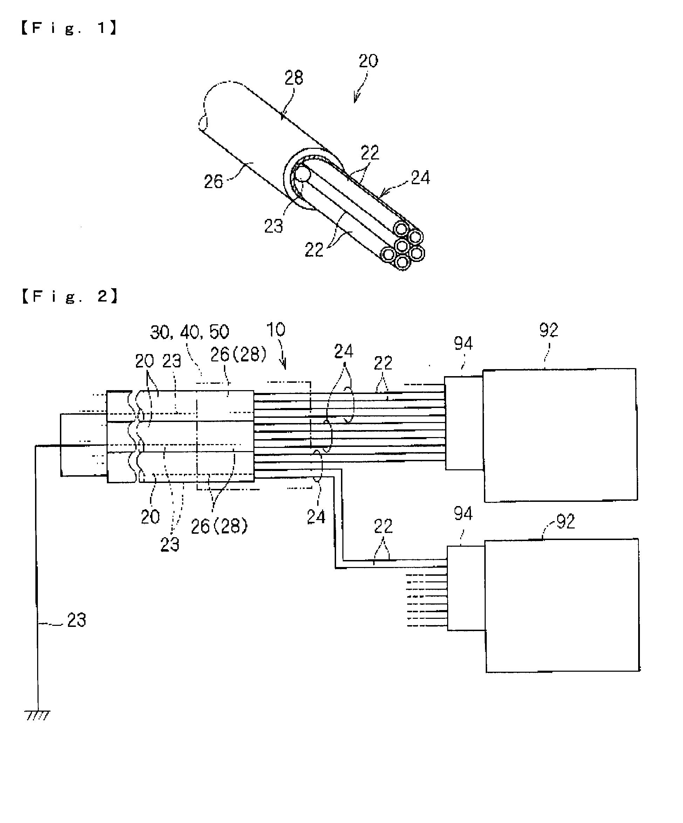

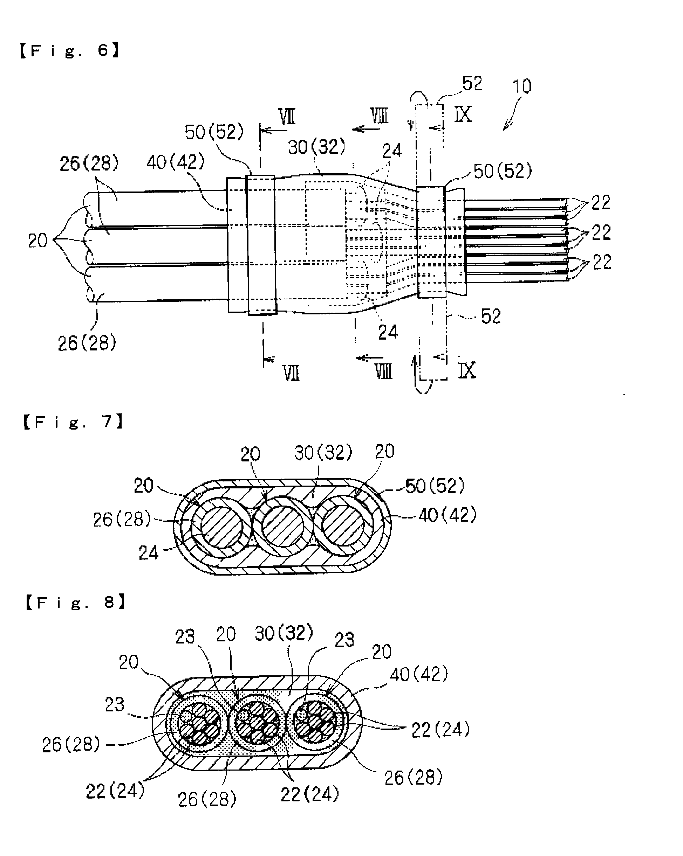

Hereinafter, a connector-connecting terminal treatment structure 10 for shielded wires according to the present invention and a method of producing the same are described (see Figs. 2 and 6).

### [1. Shielded wire]

First, for convenience of descriptions, a shielded wire 20, a target here, is described (see Fig. 1). The shielded wire 20 is an electric wire including one or a plurality (plurality, in this embodiment) of strands 22 and a drain wire 23 as a ground wiring, both of which are covered with a metal-leaf shield while the drain wire 23 is in contact with the metal-leaf shield. Alternatively, the shielded wire 20 is an electric wire in which a plurality of strands 22 are covered with a braided wire (braided shield) as a ground wiring, and the outer periphery thereof is further covered with a sheath 26 including an insulating resin coating material and the like. In this embodiment, the shielded wire 20 having the drain wire 23 is described as a target to be waterproofed. Each strand 22 is, for example, an electric wire in which a stranded wire is covered with an insulating coating material. The shielded wire 20 is used to prevent a signal wire constituting the strand 22 from being affected by noise, and is provided between an ECU (Engine Control Unit) 92 of a motor vehicle and a fuel injector. In this embodiment, in the plurality of shielded wires 20 provided between the ECU 92 and the fuel injector, a terminal portion connected with a connector on the ECU 92 side is described as a target of the terminal treatment (see Fig. 2). More specifically, the ECU 92 side of the strands 22 of the plurality of shielded wires 20 are provided through the same wiring path and are connected to one or the plurality of ECUs 92 provided in the same path.

Each shielded wire 20 includes an exposed strand portion 24 in which the plurality of strands 22 are exposed while the sheath 26 being removed at each terminal portion and a covered portion 28 in which the plurality of strands 22 are covered with the sheath 26 (see Fig. 1). A cover of strand 22 in the exposed strand portion 24 is removed at the tip thereof to be electrically connected to a terminal provided within a connector 94 that is connected to the ECU 92. The drain wire 23 is cut at the end of the sheath 26. One end of the drain wire 23 is positioned at a boundary portion between the exposed strand portion 24 and the covered portion 28 and is exposed to the exterior from the sheath 26. The other end of the drain wire 23 is grounded.

### [2. Connector-Connecting Terminal Treatment Structure for Shielded Wires]

The connector-connecting terminal treatment structure 10 for shielded wires includes the plurality of shielded wires 20, a first water stopper 30, a second water stopper 40, and a fastener 50. The plurality of shielded wires 20, which is the target of the terminal treatment, is sometimes wired in a path on the exterior of a car between the ECU 92 and the fuel injector, and is thus potentially exposed to water or the like. In the connector-connecting terminal treatment structure 10 for shielded wires, a waterproof treatment is provided at the terminal portions of the plurality of shielded wires 20. Herein, a production process of the connector-connecting terminal treatment structure 10 for shielded wires is described first, and thereafter, the configuration thereof is described.

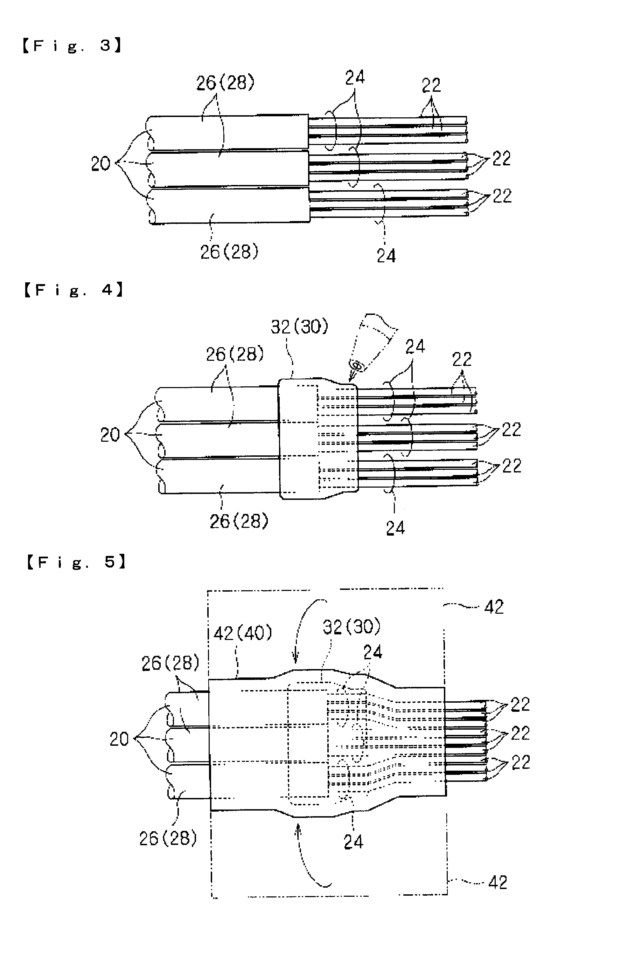

First, the plurality of shielded wires 20 are arranged in parallel to one another in a state where the ends of the covered portions 28 on the exposed strand portion 24 side are aligned to one another (step (a)). Herein, "being parallel to one another" means "not intersecting with one another" and may include errors that occur during work and errors associated with bends and twists of the shielded wires. Further, Fig. 3 shows an example in which the plurality (three, in this embodiment) of shielded wires 20 are arranged in a row in a plane; however, they may be arranged in a row to be three dimensionally parallel to one another. The extending length of the exposed strand portions 24 in the plurality of arranged shielded wires 20 may be different depending on to which the exposed strand portions 24 are connected (see Fig. 2).

Next, a paste waterproof agent 32 integrally covers (step (b), see Fig. 4) the plurality of shielded wires 20 at the boundary portion between the exposed strand portions 24 and the covered portions 28. It is preferable that the paste waterproof agent 32 be applied to a whole bundle of the plurality of shielded wires 20 so as to surround the outer periphery of the boundary portion between the exposed strand portions 24 and the covered portions 28. Thereby, an area including the end portions of the drain wires 23 exposed from the sheaths 26 of the covered portions 28 are covered with the paste waterproof agent 32. It is not necessary that the end portions of the drain wires 23 be directly covered with the paste waterproof agent 32 as long as the end portions of the drain wires 23 are located on the internal side of the paste waterproof agent 32. In addition, the paste waterproof agent 32 may be injected among the strands 22, between the strands 22 and the drain wires 23, among the sheaths 26, and within the sheath 26 of the plurality of shielded wires 20. Further, Figs. 4 to 6 show locations to which the paste waterproof agent 32 is mainly applied. In reality, however, the paste waterproof agent 32 may exist at below-described locations other than those shown in the drawings. This application work or injection work may be performed with an application device or the like having a nozzle that is capable of discharging the paste waterproof agent 32.

In addition, the application amount of the paste waterproof agent 32 may be decided in consideration of an application area and the like such that the amount is enough to cover the boundary portion between the exposed strand portions 24 and the covered portions 28 as well as to fill among the strands 22, between the strands 22 and the drain wires 23, and among the sheaths 26, when pressure is applied from the outer peripheral side. In addition, it is preferable that the application area of the paste waterproof agent 32 be set in view of waterproof performance to include the boundary portion between the exposed strand portions 24 and the covered portions 28 and to be wider than the boundary portion on both the lateral sides in the extending direction of the shielded wires 20. However, the application area may be decided in consideration of a required level of waterproof capability, costs, and the like as long as the application area includes at least the base ends of the exposed strand portions 24 and the apical ends of the covered portions 28 (ends of the drain wires 23) at the boundary portion.

By 'paste' we mean any semi-solid material which is soft and malleable when first applied; the material may be squeezable, and may be a mixture. In this embodiment the paste waterproof agent 32 is a resin material capable of being applied in a paste state and curing thereafter. For example, a moisture-curable silicone resin, urethane resin, or the like may be employed as the paste waterproof agent 32. Further, a resin material having a viscosity of 60 to 300 pascal-second is employed as the paste waterproof agent 32. Preferably, a resin material having a viscosity of 60 to 100 pascal-second is employed as the paste waterproof agent 32. In this embodiment, a resin material having a viscosity of 100 pascal-second, which is more preferable, is employed.

Next, a waterproof sheet 42 is wrapped around the plurality of shielded wires 20 so as to cover the paste waterproof agent 32 covering the boundary portion between the exposed strand portions 24 and the covered portions 28 as well as to be tightly attached to the outer periphery of the exposed strand portions 24 and the covered portions 28 on both the lateral sides of the portion covered with the paste waterproof agent 32 in the extending direction of the shielded wires 20 (step (c), see Fig. 5).

The waterproof sheet 42 is a sheet material through which the paste waterproof agent 32 does not penetrate. Herein, "the paste waterproof agent 32 does not penetrate" means that the paste waterproof agent 32 does not penetrate from one side to the other side of the waterproof sheet 42. It is necessary that at least the waterproof sheet 42 be able to hold the paste waterproof agent 32 on the internal side thereof while covering the paste waterproof agent 32. Specifically, the waterproof sheet 42 is a component that holds the paste waterproof agent 32 on the internal side thereof. The waterproof sheet 42 has an adhesive layer at least at one end portion (one end along the extending direction of the shielded wires 20 when wrapped around) of one surface thereof. The end portion having the adhesive layer is overlapped with the other end portion of the waterproof sheet 42 wrapping around the plurality of shielded wires 20. Accordingly, the waterproof sheet 42 can be kept in a wrapping state. In this embodiment, the waterproof sheet has an adhesive layer on the entirety of one surface thereof and is tightly attached to the outer periphery of the exposed strand portions 24 and the covered portions 28 of the plurality of shielded wires 20. In addition, the waterproof sheet 42 here is a soft closed-cell foam resin sheet capable of elastically deforming with ease. Accordingly, the waterproof sheet 42 enters to the further internal side of the gaps among the strands 22 located at the outer periphery of the exposed strand portions 24 and among the covered portions 28, and is tightly attached to the outer periphery of the exposed strand portions 24 and the covered portions 28 without forming any gap.

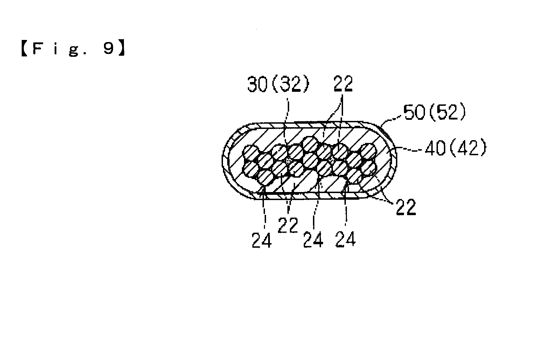

Next, a tape 52 is wound around the outer periphery of the waterproof sheet 42 on at least one lateral side (both lateral sides in this embodiment) of the portion where the paste waterproof agent 32 is applied in the extending direction of the plurality of shielded wires 20 (step (d), see Fig. 6). The tape 52 is an adhesive tape made from PVC (polyvinyl chloride) or the like and having an adhesive layer on one surface thereof. Specifically, the tape 52 is wound around the waterproof sheet 42 wrapping around the plurality of shielded wires 20 so as to tighten it up and keep the state. Accordingly, a portion of the waterproof sheet 42 wound by the tape 52 is pressed and tightly attached to the outer periphery of each strand 22 and each sheath 26 in each of the plurality shielded wires 22 without forming any gap (see Figs. 7 and 9).

When above-described steps (c) and (d) are performed, the waterproof agent 32 is in a paste (not cured) state. Then, pressure is added to the waterproof sheet 42 wrapping around and covering the paste waterproof agent 32 from the outer periphery side to the inner periphery side. Accordingly, in the plurality of shielded wires 20, the paste waterproof agent 32 is filled among the strands 22, between the strands 22 and the drain wires 23, among the sheaths 26, and between the strands 22 and drain wires 23 at the end of the covered portions 28 and the sheaths 26. At this time, the paste waterproof agent 32 is prevented from straying to the outer periphery side as well as the lateral sides in the extending direction of the shielded wires 20 by the waterproof sheet 42 covering around the paste waterproof agent 32. The paste waterproof agent 32 thus stays at the boundary portion, the portion to be waterproofed, between the exposed strand portions 24 and the covered portions 28. The paste waterproof agent 32 sometimes moves in the extending direction of the shielded wires 20, while passing through a narrow gap among the strands 22, among sheaths 26, and between the exposed strand portions 24 or the covered portions 28 and the waterproof sheet 42. Due to high viscosity, however, the paste waterproof agent 32 is prevented from leaking out to the exterior of the waterproof sheet 42 (see Fig. 9).

Furthermore, the work to pressurize the waterproof sheet 42 may be performed before or after step (d).

Thereafter, the paste waterproof agent 32 cures, and thereby, the connector-connecting terminal treatment structure 10 for shielded wires is completed (see Fig. 6). The connector-connecting terminal treatment structure 10 for shielded wires prepared in the steps above includes the plurality of shielded wires 20, the first water stopper 30, the second water stopper 40, and the fastener 50.

In summary, the first water stopper 30 covers the boundary portion between the exposed strand portions 24 and the covered portions 28 in the plurality of shielded wires 20. At the same time, the second water stopper 40 covers the outer periphery of the first water stopper 30 and its lateral sides in the extending direction of the plurality of shielded wires 20. In addition, the fastener 50 winds around the outer periphery of the second water stopper 40 at both lateral sides of the first water stopper 30 in the extending direction of the plurality of shielded wires 20. Furthermore, in Figs. 7 and 8, the exposed strand portions 24 are schematically illustrated in a circular shape from the cross-sectional view perpendicular to the extending direction.

The first water stopper 30 is configured with the cured paste waterproof agent 32. The first water stopper 30 covers the boundary portion between the exposed strand portions 24 and the covered portions 28, between a pair of fasteners 50. Accordingly, the first water stopper 30 partially or fully exists between the plurality of shielded wires 20 and the second water stopper 40 (see Figs. 6 and 8). In addition, the first water stopper 30 also exists among strands 22 and among the sheaths 26 in the plurality of shielded wires 20 between the pair of fasteners 50 (at least around the boundary portion between the exposed strand portions 24 and the covered portions 28). Further, the first water stopper 30 also exists between the strands 22 and the drain wires 23, and between the sheaths 26, and the strands 22 and the drain wires 23. Furthermore, the first water stopper 30 may exist among the strands 22 and among the sheaths 26 located on the internal periphery side of the pair of fasteners 50 (see Figs. 7 and 9).

The second water stopper 40 is configured with the waterproof sheet 42 wrapping around the plurality of shielded wires 20. The second water stopper 40 is tightly attached to the outer periphery of the first water stopper 30 (see Fig. 8) as well as to the outer periphery of the bundle of exposed strand portions 24 and covered portions 28 at the lateral sides of the first water stopper 30 (see Figs. 7 and 9). In addition, the internal periphery of the second water stopper 40 that is tightly attached to the outer periphery of the exposed strand portions 24 and the covered portions 28 is kept in a shape elastically deformed along the outer periphery of the exposed strand portions 24 and the covered portions 28. Further, the portion of the second water stopper 40 that are located on the internal periphery side of the pair of fasteners 50 are kept in a shape elastically deformed along more portions of the outer periphery of the exposed strand portions 24 and the covered portions 28.

The fastener 50 is configured with the tape 52 wrapping around the second water stopper 40. The fastener 50 surrounds the outer periphery of the second water stopper 40 in a state where the second water stopper 40 is pressed to the internal side and is elastically deformed (see Figs. 7 and 9).

The descriptions above have been provided using an example where the plurality of shielded wires 20 are arranged in a row in a state where the ends of the covered portions 28 on the exposed strand portion 24 side are aligned. However, the plurality of shielded wires 20 may be arranged in a row in a state where the ends of the covered portions 28 are not aligned. In such a case, it is also preferable that the paste waterproof agent 32 be applied to integrally cover the boundary portion between the exposed strand portions 24 and the covered portions 28 of the plurality of shielded wires 20.

Further, the above descriptions have been provided using an example where the paste waterproof agent 32 is directly applied to the plurality of shielded wires 20. However, the waterproof sheet 42 applied with the paste waterproof agent 32 on one side thereof may be wrapped around the plurality of shielded wires 20. Thereby, the boundary portion between the exposed strand portions 24 and the covered portions 28 may be integrally covered with the paste waterproof agent 32. In other words, step (b) and step (c) in the production process may be concurrently performed.

Further, the above descriptions have been provided using an example where the end portion of the drain wire 23 of each shielded wire 20 is located in a position substantially the same as the end of the sheath 26. However, the end portion of the drain wire 23 may be located on the exposed strand portion 24 side with respect to the sheath 26, for example. In such a case, it is also preferable the structure 10 for shielded wires be configured such that the end portion of the drain wire 23 exposed from the sheath 26 is located on the internal side of the first water stopper 30 and the second water stopper 40. It is further preferable that the end portion of the drain wire 23 be located on the internal side of the pair of the fasteners 50.

Furthermore, the end portion of the drain wire 23 on the exposed strand portion 24 side may be connected to the grounding electrode of the ECU 92. In such a case, it is preferable that a covered electric wire be connected to the tip of the drain wire 23, and a portion of the drain wire 23 exposed between the sheath 26 and the covered tip be covered with the first water stopper 30 and the second water stopper 40.

Furthermore, winding of the tape 52, that is, the fastener 50, may be omitted. In this example, since the adhesive layer is provided over the entirety of a surface of the waterproof sheet 42, the waterproof sheet 42 alone can be tightly attached to the outer periphery of the exposed strand portions 24 and the covered portions 28. When no adhesive layer is provided to a portion of the waterproof sheet 42 to be tightly attached to the outer periphery of the exposed strand portions 24 and the covered portions 28, the waterproof sheet 42 may be tightly attached to the outer periphery of the exposed strand portions 24 and the covered portions 28 by winding the tape 52.

Furthermore, the above descriptions have been provided using an example where the paste waterproof agent 32 is a material that cures after being applied, and the first water stopper 30 is configured with the cured paste waterproof agent 32; however, the present invention is not limited to these. Specifically, in a case where the paste waterproof agent 32 having relatively high viscosity is used for the application step, the paste waterproof agent 32 may keep the same viscosity without curing, as long as the first water stopper 30 covers and stays at the boundary portion between the exposed strand portions 24 and the covered portions 28. Further, in the first water stopper 30, the paste waterproof agent 32 does not have to be fully cured as long as it changes its state to have a viscosity high enough to stay at the portion to be waterproofed.

In the connector-connecting terminal treatment structure 10 for shielded wires and the method of producing the same according to the present embodiment, the first water stopper 30 is configured with the cured paste waterproof agent 32 that is applied so as to integrally cover the boundary portion between the exposed strand portions 24 and the covered portions 28. Accordingly, it is possible for the paste waterproof agent 32 to stay at the boundary portion, the target portion to be waterproofed, between the exposed strand portions 24 and the covered portions 28 without flowing away. Thereby, it is possible to ensure a waterproof capability. Furthermore, the second water stopper 40 is configured with the waterproof sheet 42 through which the paste waterproof agent 32 does not penetrate. In addition, the second water stopper 40 covers the outer periphery of the first water stopper 30 as well as tightly attaches to the outer periphery of the exposed strand portions 24 and the covered portions 28 on both the lateral sides of the first water stopper 30 in the extending direction of the shielded wires 20. Accordingly, it is possible to prevent the paste waterproof agent 32 from leaking out from the second water stopper 40 before curing. It is also possible to easily treat the plurality of shielded wires 20 while ensuring the waterproof capability by keeping the paste waterproof agent 32 at the portion to be waterproofed.

Furthermore, the first water stopper 30 also exists among the strands 22 and among the sheaths 26 at the boundary portion between the exposed strand portions 24 and the covered portions 28. Accordingly, it is possible to obtain a high waterproof capability.

Furthermore, the second water stopper 40 is made from a closed-cell foam resin sheet and is thus soft and elastically deformable with ease. Accordingly, the second water stopper 40 tightly attaches to the outer periphery of the shielded wires 20 without forming any gap in order to prevent the paste waterproof agent 32 from leaking. Thereby, it is possible to increase the waterproof capability.

Furthermore, the fasteners 50 wind around the outer periphery of the second water stopper 40 on both the lateral sides of the first water stopper 30 in the extending direction of the shielded wires 20. Accordingly, the second water stopper 40 is more strongly pressed against the outer periphery of the exposed strand portions 24 and the covered portions 28. Accordingly, it is possible to prevent the paste waterproof agent 32 before curing of the first water stopper 30 from straying away in the extending direction of the shielded wires 20 as well as to securely keep the paste waterproof agent 32 before curing at the boundary portion between the exposed strand portions 24 and the covered portions 28, thereby improving the waterproof capability.

Furthermore, with the paste waterproof agent 32 covering the area including the end portions of the drain wires 23 exposed from the sheaths 26 of the covered portions 28, the first water stopper 30 covering the end portions of the drain wires 23 is formed. Thereby, the water can be securely stopped from penetrating to the drain wires 23 as well.

### DESCRIPTION OF REFERENCE NUMERALS

- 10: Connector-connecting terminal treatment structure for shielded wires
- 20: Shielded wire
- 22: Strand
- 24: Exposed strand portion
- 26: Sheath
- 28: Covered portion
- 30: First water stopper
- 32: Waterproof agent
- 40: Second water stopper
- 42: Waterproof sheet
- 50: Fastener
- 52: Tape
- 94: Connector

## Claims

1. A connector-connecting terminal treatment structure (10) for shielded wires having a terminal portion connected to a connector, comprising:
a plurality of shielded wires (20) arranged in parallel to one another;
a first water stopper (30) configured with a paste waterproof agent; and
a second water stopper (40) having a sheet shape through which the paste waterproof agent does not penetrate,
the plurality of shielded wires comprising a strand and a ground wiring covered with a sheath and each having an exposed strand portion in which the strand is exposed at a terminal portion and a covered portion in which the strand and the ground wiring are covered with the sheath,
the first water stopper integrally covering a boundary portion between the exposed strand portions and the covered portions of the plurality of shielded wires, and
the second water stopper covering an outer periphery of the first water stopper as well as tightly attaching to an outer periphery of the covered portions and said exposed strand portion on both the lateral sides of the first water stopper in an extending direction of the plurality of shielded wires.

2. The connector-connecting terminal treatment structure for shielded wires according to claim 1, wherein the first water stopper (30) also exists among the strands and among the sheaths at the boundary portion between the exposed strand portions and the covered portions.

3. The connector-connecting terminal treatment structure for shielded wires according to claim 1 or claim 2, wherein the second water stopper (40) comprises closed-cell foam resin sheet.

4. The connector-connecting terminal treatment structure for shielded wires according to any one of claims 1 to 3, further comprising:
a fastener (50) winding around an outer periphery of the second water stopper (40) on at least one lateral side of the first water stopper (30) in the extending direction of the shielded wires.

5. The connector-connecting terminal treatment structure for shielded wires according to any one of claims 1 to 4, wherein the first water stopper (30) covers end portions of ground wirings exposed from the sheaths of the covered portions.

6. A method of producing a connector-connecting terminal treatment structure for shielded wires that performs a terminal treatment on a plurality of shielded wires, each of the plurality of shielded wires comprising a strand and a ground wiring covered with a sheath and having an exposed strand portion in which the strand is exposed at a terminal portion and a covered portion in which the strand and the ground wiring are covered with the sheath, the method comprising:
(a) arranging the plurality of shielded wires to be substantially parallel to one another;
(b) integrally covering a boundary portion between the exposed strand portions and the covered portions of the plurality of shielded wires with a paste waterproof agent; and
(c) wrapping a waterproof sheet, through which the paste waterproof agent does not penetrate, around the plurality of shielded wires so as to cover the paste waterproof agent covering the boundary portion between the exposed strand portions and the covered portions as well as to tightly attach to the outer periphery of the exposed strand portions and the covered portions on both the lateral sides of a portion covered with the paste waterproof agent in the extending direction of the shielded wires.

7. The method of producing the connector-connecting terminal treatment structure for shielded wires according to claim 6, further comprising:
(d) winding a tape around the outer periphery of the waterproof sheet on at least one lateral side of the portion covered with the paste waterproof agent in the extending direction of the shielded wires.

8. The method of producing the connector-connecting terminal treatment structure for shielded wires according to one of claim 6 and claim 7, wherein, in (b), an area including end portions of the ground wirings exposed from the sheaths of the covered portions is covered with the paste waterproof agent.
